Europäisches Patentamt

European Patent Office

Office européen des brevets

(19)

(11) Veröffentlichungsnummer: **0 148 317**
**A1**

(12) ## EUROPÄISCHE PATENTANMELDUNG

(21) Anmeldenummer: **84108731.5**

(22) Anmeldetag: **24.07.84**

(51) Int. Cl.⁴: **H 01 L 21/302, C 11 D 1/44**

(30) Priorität: **09.08.83 DE 3328639**

(43) Veröffentlichungstag der Anmeldung: **17.07.85**
**Patentblatt 85/29**

(84) Benannte Vertragsstaaten: **CH DE FR GB LI**

(71) Anmelder: **Merck Patent Gesellschaft mit beschränkter Haftung, Frankfurter Strasse 250, D-6100 Darmstadt (DE)**

(72) Erfinder: **Urban, Manfred, Dr., Mainzer Strasse 14, D-6108 Weiterstadt (DE)**

(54) Reinigungsmittel für mechanisch bearbeitete Halbleitermaterialien.

(57) Ein wäßrig-alkalisches, tensidhaltiges Reinigungsmittel, das als Reinigungszusatz Fettaminethoxylate enthält, eignet sich in hervorragender Weise als Reinigungsmittel für mechanisch bearbeitete Halbleitermaterialien.

EP 0 148 317 A1

0148317

## Reinigungsmittel für mechanisch bearbeitete Halbleitermaterialien.

Die Erfindung betrifft ein Reinigungsmitel für mechanisch bearbeitete Halbleitermaterialien. Halbleitermaterialien zur Herstellung von elektronischen und mikroelektronischen Bauteilen werden üblicherweise in Form dünner Scheiben verarbeitet. Es handelt sich hierbei in den überwiegenden Fällen um hochreines Silicium, das in Form von ein- oder polykristallinen Stäben aus Schmelzen gezogen wird. Diese werden, gegebenenfalls nach weiteren Reinigungsoperationen wie etwa Zonenschmelzen, in dünne Scheiben zersägt. Durch diesen Sägevorgang erhalten die Scheiben eine stark strukturierte Oberfläche, die unerwünscht ist und die darüber hinaus den feinen Sägestaub gut festhält. Für die weitere Verarbeitung zu Halbleiterbauteilen ist es aber erforderlich, daß diese Scheiben eine absolut glatte und ebene Oberfläche, frei von jeglichen Verunreinigungen, aufweisen. Aus diesem Grund werden die Halbleiterscheiben zur Glättung ihrer Oberfläche weiter mechanisch bearbeitet, d.h. sie werden poliert oder geläppt, meist unter Zuhilfenahme von Polier- oder Läppmaterialien. Diese enthalten feine, harte Partikel, z.B. Metalloxide, die für eine effiziente Einebnung der Halbleiteroberfläche sorgen. Diese Materialien setzen sich zusätzlich zum feinen Sägestaub in die trotzdem noch verbleibenden feinen Vertiefungen der Scheibenoberflächen. Vor dem weiteren Einsatz der so bearbeiteten Halbleiterscheiben müssen alle Verunreinigungen und die letzten leichten Oberflächenunregelmäßigkeiten durch Reinigungs- und/oder Ätzbäder quantitativ entfernt werden. Hierzu setzt man üblicherweise die Scheiben diversen Reinigungsbädern aus, die teilweise stark alkalisch sind, wobei durch Alkalien letzte Oberflächenrauigkeiten weggeätzt werden.

Für diese Zwecke mehr oder weniger geeignete Reinigungsmittel sind aus dem Spektrum der Industrie- und Spezialreiniger bekannt. Es sind dies meist wäßrig-alkalische, tensidhaltige Lösungen, die schmutzlösend, emulgierend und insbesondere dispergierend wirken sollen. Das Reinigungsverhalten und die Schmutztragefähigkeit solcher Mittel wird beeinflußt von den in ihnen enthaltenen Anteilen an Tensiden, hydrotropen Substanzen und sonstigen in der Technologie der Reinigungsmittel üblichen Zusätzen. So enthalten beispielsweise gängige Reiniger in wäßrig-alkalischer Lösung anionische Tenside, etwa vom Typ der Alkylbenzolsulfonate, gegebenenfalls auch nichtionogene Tenside, hydrotrope Substanzen und Alkaliphosphate zur pH-Wert-Pufferung sowie zur weiteren Regulierung der Reinigungskraft und des Dispergierverhaltens.

Von Fettalkoholethoxylaten als nichtionogene Tenside ist bekannt, daß sie als Zusatz zu Reinigungsmitteln deren Schmutzlöse- und Dispergierfähigkeit wesentlich verstärken können. Es zeigt sich jedoch, daß diese Substanzen für den vorbeschriebenen Verwendungszweck wenig geeignet sind. Für eine Anwendung bei der Reinigung von mechanisch bearbeiteten Halbleitermaterialien, wobei bevorzugt bei erhöhten Temperaturen im Bereich zwischen etwa 50 und 100 °C und unter Anwendung von Ultraschall gearbeitet wird, zeigen niedrigethoxylierte Fettalkohole zu niedrige Trübungspunkte, d.h. sie scheiden sich bei erhöhter Temperatur aus dem Reinigungsbad aus und werden somit unwirksam. Höher ethoxylierte Fettalkohole mit höher liegendem Trübungspunkt führen dagegen zu einem starken Schäumen, was ebenfalls unerwünscht ist.

Ein dem vorliegenden Verwendungszweck optimal geeignetes nichtionogenes Tensid war bisher nicht bekannt.

Es bestand somit die Aufgabe, ein entsprechendes Tensid aufzufinden und ein Reinigungsmittel zu entwickeln, das für die Reinigung mechanisch bearbeiteter Halbleitermaterialien sehr gut geeignet ist.

Überraschenderweise wurde nun gefunden, daß sich Fettaminethoxylate in hervorragender Weise als Reinigungszusatz zu Reinigungsmitteln für mechanisch bearbeitete Halbleitermaterialien eignen.

Diese Substanzklasse verfügt über ein ausgezeichnetes Schmutzlöse- und Dispergierverhalten und ist gegenüber anderen nichtionogenen Tensiden in einem bemerkenswert weiten Temperaturintervall anwendbar bei gleichzeitig geringer Neigung zur Schaumbildung.

Gegenstand der Erfindung ist somit ein wäßrig-alkalisches, tensidhaltiges Reinigungsmittel für mechanisch bearbeitete Halbleitermaterialien, das als Reinigungszusatz Fettaminethoxylate enthält.

Gegenstand der Erfindung ist weiterhin die Verwendung von Fettaminethoxylaten als Reinigungszusatz in Reinigungsmitteln für mechanisch bearbeitete Halbleitermaterialien.

Gegenstand der Erfindung ist darüber hinaus auch ein Verfahren zur Reinigung von mechanisch bearbeiteten Halbleitermaterialien, wobei diese mit wäßrig-alkalischen, tensidhaltigen Reinigungsmitteln behandelt werden, die als Reinigungszusatz Fettaminethoxylate enthalten.

Unter mechanisch bearbeiteten Halbleitermaterialien sind hier prinzipiell alle Gegenstände aus Halbleitermaterial zu verstehen, deren Oberflächen nach einer formgebenden mechanischen Bearbeitung, wie etwa Sägen, Schleifen, Polieren, Läppen usw., einer eingehenden Reinigung bedürfen. Vornehmlich handelt es sich hier um Silicium, das aus Schmelzen zu Stäben gezogen und anschließend in dünne Scheiben zersägt wird.

Das Reinigungsmittel hierfür hat die Aufgabe, sämtliche Verunreinigungen vollständig und bei kurzer Behandlungsdauer auch aus den feinsten Oberflächenunebenheiten der Halbleitermaterialien zu lösen und diesen Schmutz in der Lösung verteilt zu halten. Dabei muß es bei erhöhter Temperatur bis etwa 100 °C bei Anwesenheit von starkem Alkali und bei Anwendung von Ultraschall über mehrere Stunden hinweg stabil bleiben und darf beim Reinigungsvorgang nicht schäumen. Für die praktische Verwendbarkeit ist es außerdem erforderlich, daß das Reinigungsmittel eine ausreichende Lagerstabilität, auch bei tieferen Temperaturen um etwa 0 °C, aufweist.

Durch den erfindungsgemäßen Zusatz von Fettaminethoxylaten zu wäßrig-alkalischen Reinigungsmitteln werden diese Aufgaben und Erfordernisse in ausgezeichneter Weise erfüllt.

Fettaminethoxylate - auch als Fettaminpolyglycolether bezeichnet - sind Additionsprodukte von primären Fettaminen mit Ethylenoxid und werden in beliebiger Zusammensetzung industriell hergestellt. Sie werden charakterisiert durch die Kohlenstoffzahl der Fettaminkohlenwasserstoffkette sowie durch den Ethoxylierungsgrad.

Letztere gibt die Zahl der am Fettaminstickstoff angelagerten
Ethylenoxidgruppen an. Die grenzflächenaktiven Eigenschaften
dieser Fettaminethoxylate wird bestimmt durch Art und Länge
der hydrophoben Fettaminkohlenwasserstoffkette sowie Anzahl
der Ethoxylgruppen in den hydrophilen Polyglycoletherketten.

Für den erfindungsgemäßen Verwendungszweck sind die Fettaminethoxylate bezüglich dieser Merkmale in einem weiten Bereich
einsetzbar. Art und Länge der Kohlenwasserstoffkette, der zur
Anwendung gelangenden Fettaminethoxylate sind weniger kritisch.
Aufgrund ihrer leichten Verfügbarkeit sind solche mit gesättigten und ungesättigten Kohlenwasserstoffketten von 8 - 20 C-Atomen
bevorzugt. Besonders bevorzugt sind solche Fettaminethoxylate,
die sich von Kokosfettamin, Oleylamin, Stearylamin und Talgfettamin ableiten.

Fettaminethoxylate mit Ethoxylierungsgraden von 3 - 15 zeigen
keine Neigung zur Schaumbildung und verfügen über so hoch
liegende Trübungspunkte, daß sie auch bei Temperaturen bis zu
etwa 100 °C eingesetzt werden können, ohne sich hierbei aus
der Reinigungslösung abzuscheiden und ihre schmutzlösende und
dispergierende Wirkung einzubüßen. Besonders bevorzugt sind
Ethoxylate mit Ethoxylierungsgraden von 8 - 12.

In den erfindungsgemäßen Reinigungsmitteln für mechanisch
bearbeitete Halbleitermaterialien ist die Konzentration
dieser Fettaminethoxylate in einem weiten Bereich variabel.
Als wirksam und ausreichend haben sich Konzentrationen von
0,1 - 5, vorzugsweise 0,25 - 1 Gew.%, bezogen auf die Gesamtmenge an Reinigungsmittel, herausgestellt. Hierbei können
bezüglich der Merkmale Art und Länge der Kohlenwasserstoffkette und Ethoxylierungsgrad diskrete oder auch Gemische
bzw. Verschnitte verschiedener Fettaminethoxylate zum Einsatz
gelangen.

Neben diesen, für den erfindungsgemäßen Verwendungszweck wesentlichen Fettaminethoxylaten enthält das Reinigungsmittel noch weitere, für die Steuerung des Schmutzlöse- und Dispergierverhaltens übliche Substanzen. Dies können sein Alkalimetallhydroxide wie Natronlauge und Kalilauge zur pH-Wert-Einstellung, Alkalimetallphosphate wie Natrium- bzw. Kaliummono-, -di-, -tri- oder polyphosphat zur pH-Wert-Pufferung, Bindung der Wasserhärte und weiteren Regulierung der Schmutzlöse- und Schmutztragefähigkeit. Weiterhin können enthalten sein hydrotrope Substanzen wie etwa Cumolsulfonat oder Toluolsulfonat, anionische Tenside etwa vom Typ der Alkylbenzolsulfonate wie z.B. Dodecylbenzolsulfonat. Günstig ist auch der Zusatz von geringen Mengen an Alkoholen oder Polyglycolen als Lösungsvermittler, da sich hierdurch die Homogenität der Reinigungslösung, insbesondere die Lagerstabilität bei niedrigen Temperaturen, optimal einstellen läßt. Im übrigen können dem erfindungsgemäßen Reiniger noch weitere, in der Technologie der Reinigungsmittel übliche Hilfs- und Zusatzstoffe beigegeben werden. Der Fachmann dieses Gebietes kann leicht durch qualitative wie quantitative Variation der Inhaltsstoffe, ausgehend von den nachfolgenden Rezepturbeispielen, den Reiniger seinen spezifischen Erfordernissen anpassen.

Das erfindungsgemäße Reinigungsverfahren erfolgt in der Weise, daß man die zu reinigenden Halbleitermaterialien nach der mechanischen Bearbeitung in eines oder nacheinander in mehrere der erfindungsgemäßen Reinigungsmittelbäder verbringt und diese einige Zeit einwirken läßt. Vorteilhaft ist es hierbei, zur Beschleunigung erhöhte Temperaturen etwa zwischen 50 und 100 °C, vorzugsweise 80-95 °C, und Ultraschall anzuwenden. Falls erforderlich, kann das Reinigungsbad durch Zusatz von Lauge alkalisch aufkonzentriert oder auch mit Wasser verdünnt werden. Sämtliche Verunreinigungen werden durch diese Behandlung quantitativ abgelöst; nach einem eventuellen Nachspülen mit reinem Wasser und/oder Alkohol und Trocknen sind die gereinigten Halbleitermaterialien für die weitere Verarbeitung bereit.

Beispiel 1

Reinigungsmittel aus

10,0 Gew.% Kaliummonophosphat
10,0 Gew.% Natrium-Cumolsulfonat
 7,5 Gew.% Natrium-Dodecylbenzolsulfonat
 1,0 Gew.% Fettaminethoxylat (Kohlenwasserstoff-Kettenlänge 8; Ethoxylierungsgrad 6)
Rest: Wasser

Beispiel 2

Reinigungsmitel aus

12,0 Gew.% Kaliumdiphosphat
13,5 Gew.% Natrium-Cumolsulfonat
 3,5 Gew.% Natrium-Dodecylbenzolsulfonat
 0,5 Gew.% Natriumhydroxid
 0,5 Gew.% Kokosfettaminethoxylat
        (Ethoxylierungsgrad 10)
 0,1 Gew.% Polyethylenglycol 1000
Rest: Wasser

Beispiel 3

Reinigungsmittel aus

15,0 Gew.% Kaliumdiphosphat

12,0 Gew.% Natrium-Cumolsulfonat

5,0 Gew.% Natrium-Dodecylbenzolsulfonat

0,5 Gew.% Fettaminethoxylat (Kohlenwasserstoff-Kettenlänge 12; Ethoxylierungsgrad 12)

0,1 Gew.% Polyethylenglycol 600

Rest: Wasser

Beispiel 4

Reinigungsmittel aus

6,0 Gew.% Kaliumdiphosphat

6,0 Gew.% Kaliumtripolyphosphat

14,0 Gew.% Natrium-Cumolsulfonat

3,0 Gew.% Fettaminethoxylat (Kohlenwasserstoff-Kettenlänge 10; Ethoxylierungsgrad 6)

0,1 Gew.% Polyethylenglycol 2000

Rest: Wasser

Beispiel 5

Reinigungsmittel aus

5,0 Gew.% Kaliumdiphosphat

5,0 Gew.% Kaliumtripolyphosphat

13,0 Gew.% Natrium-Cumolsulfonat

13,0 Gew.% Fettaminethoxylat (Kohlenwasserstoff -
   Kettenlänge 10; Ethoxylierungsgrad 6)

0,1 Gew.% Polyethylenglycol 1000

Rest: Wasser

**Beispiel 6**
Reinigungsmittel aus

 2,0 Gew.% Kaliumphosphat
 4,0 Gew.% Kaliumdiphosphat
 6,0 Gew.% Kaliumtripolyphosphat
13,6 Gew.% Natrium-Cumolsulfonat
 3,5 Gew.% Natrium-Dodecylbenzolsulfonat
 0,5 Gew.% Fettaminethoxylat (Kohlenwasserstoff -
          Kettenlänge 12; Ethoxylierungsgrad 10)
 0,5 Gew.% Natriumhydroxid
 0,1 Gew.% Polyethylenglycol 1000
Rest: Wasser

**Beispiel 7**

Reinigung von Silicium-Scheiben

Die gesägten und geläppten Silicium-Scheiben werden 2 Stunden bei 80 °C im Ultraschallbad mit einer 10 %igen wäßrigen Lösung eines Reinigungsmittels nach Beispiel 6 behandelt. Hierbei werden Säge- und Läppstaub vollständig abgelöst und in der Reinigungslösung dispergiert. Die Lösung bleibt klar; eine Schaumentwicklung wird nicht beobachtet.

Nach einer Spülung mit destilliertem Wasser und Isopropanol und Trocknung wird die Scheibenoberfläche vollständig gesäubert.

0148317

Merck Patent Gesellschaft
mit beschränkter Haftung
D a r m s t a d t


P a t e n t a n s p r ü c h e


1.  Wäßrig-alkalisches, tensidhaltiges Reinigungsmittel
    für mechanisch bearbeitete Halbleitermaterialien,
    dadurch gekennzeichnet, daß es als Reinigungszusatz Fettaminethoxylate enthält.


2.  Reinigungsmittel nach Anspruch 1, dadurch gekennzeichnet, daß es Fettaminethoxylate mit Ethoxylierungsgraden von 3 bis 15, vorzugsweise 8 bis 12,
    enthält.

3. Reinigungsmittel nach den Ansprüchen 1 und 2, dadurch gekennzeichnet, daß es Fettaminethoxylate in einer Konzentration von 0,1 bis 5, vorzugsweise 0,25 bis 1 Gew.-%, bezogen auf die Gesamtmenge, enthält.

4. Verwendung von Fettaminethoxylaten als Zusatz zu Reinigungsmitteln für mechanisch bearbeitete Halbleitermaterialien.

5. Verfahren zur Reinigung von mechanisch bearbeiteten Halbleitermaterialien, wobei diese mit wäßrig-alkalischen, tensidhaltigen Reinigungsmitteln behandelt werden, dadurch gekennzeichnet, daß ein Reinigungsmittel nach den Ansprüchen 1 - 3 verwendet wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-2 526 052 (WACKER-CHEMITRONIC) * Ansprüche 1,2; Seite 2 * | 1 | H 01 L 21/302 C 11 D 1/44 |
| A | | 5 | |
| | --- | | |
| Y | DE-B-2 507 156 (HOECHST) * Ansprüche 1,6 * | 1 | |
| | --- | | |
| A | DE-C-1 041 003 (FARBENFABRIKEN BAYER) * Patentanspruch * | 1 | |
| | ----- | | |

RECHERCHIERTE SACHGEBIETE (Int. Cl.4)

H 01 L 21/302
C 11 D 1/44

Der vorliegende Recherchenbericht wurde für alle Patentansprüche erstellt.

| Recherchenort | Abschlußdatum der Recherche | Prüfer |
|---|---|---|
| BERLIN | 31-10-1984 | ROTHER A H J |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03.82